# EUROPEAN PATENT APPLICATION

(11) **EP 4 815 674 A2**
(43) Date of publication of application: **30.09.2026**
(21) Application number: 25222747.5
(22) Date of filing: 11.12.2025
(51) Int. Cl.: H10D 84/01, H10D 30/01, H10D 30/00, H10D 64/23, H10D 84/03, H10D 84/83, H10D 84/85

(54) **STANDARD CELL ARCHITECTURE WITH FRONTSIDE AND BACKSIDE CONNECTIONS**

(30) Priority: 27.03.2025 US 202519092453
(71) Applicant: Intel Corporation, Santa Clara, CA 95054 (US)
(72) Inventor: LI, Xia, San Diego, CA 92130 (US); CHEHAB, Bilal, Portland, OR 97202 (US); LIU, Ming-Xu, Maricopa, AZ 85138 (US); APRAMEYAN, Prashanth, San Jose, CA 95135 (US)
(74) Representative: HGF

(57) **Abstract**

Techniques are provided herein to form an integrated circuit with a standard cell layout that can utilize both frontside and backside connections along with a tighter pitch between the devices. The standard cell layout may include two total transistors with one transistor being an n-channel device with the other being a p-channel device. A pitch between the transistors may be reduced compared to conventional layouts in part due to a reduction in a thickness of a shallow trench isolation (STI) layer. The thinner STI layer reduces the aspect ratio (AR) of backside contacts made beneath source or drain regions of the devices. In some such examples, each of the devices of the standard cell may be gate-all-around transistors each having any number of nanoribbons extending in the same direction. Other standard cell layouts may include four total transistors arranged in a NAND or a NOR configuration.

## Description

### BACKGROUND

As integrated circuits continue to scale downward in size, a number of challenges arise. For instance, pitch scaling between adjacent devices of memory and logic cells becomes increasingly difficult as the gate lengths continue to decrease. Delivering power and ground rails to such devices also becomes difficult. Accordingly, there remain a number of non-trivial challenges with respect to forming such high-density semiconductor devices.

### BRIEF DESCRIPTION OF THE DRAWINGS

Figures 1A - 1C are plan views of different standard cell layouts having devices with both frontside and backside connections, in accordance with some embodiments of the present disclosure.
Figures 2A and 2B are plan and cross-sectional views that illustrate one stage in an example process for forming a standard cell layout of an integrated circuit with frontside and backside connections, in accordance with an embodiment of the present disclosure.
Figures 3A and 3B are plan and cross-sectional views that illustrate another stage in the example process for forming a standard cell layout of an integrated circuit with frontside and backside connections, in accordance with an embodiment of the present disclosure.
Figures 4A and 4B are plan and cross-sectional views that illustrate another stage in the example process for forming a standard cell layout of an integrated circuit with frontside and backside connections, in accordance with an embodiment of the present disclosure.
Figures 5A and 5B are plan and cross-sectional views that illustrate another stage in the example process for forming a standard cell layout of an integrated circuit with frontside and backside connections, in accordance with an embodiment of the present disclosure.
Figures 6A and 6B are plan and cross-sectional views that illustrate another stage in the example process for forming a standard cell layout of an integrated circuit with frontside and backside connections, in accordance with an embodiment of the present disclosure.
Figures 7A and 7B are plan and cross-sectional views that illustrate another stage in the example process for forming a standard cell layout of an integrated circuit with frontside and backside connections, in accordance with an embodiment of the present disclosure.
Figures 8A and 8B are plan and cross-sectional views that illustrate another stage in the example process for forming a standard cell layout of an integrated circuit with frontside and backside connections, in accordance with an embodiment of the present disclosure.
Figures 9A and 9B are plan and cross-sectional views that illustrate another stage in the example process for forming a standard cell layout of an integrated circuit with frontside and backside connections, in accordance with an embodiment of the present disclosure.
Figures 10A and 10B are plan and cross-sectional views that illustrate another stage in the example process for forming a standard cell layout of an integrated circuit with frontside and backside connections, in accordance with an embodiment of the present disclosure.
Figures 11A and 11B are plan and cross-sectional views that illustrate another stage in the example process for forming a standard cell layout of an integrated circuit with frontside and backside connections, in accordance with an embodiment of the present disclosure.
Figures 12A and 12B are plan and cross-sectional views that illustrate another stage in the example process for forming a standard cell layout of an integrated circuit with frontside and backside connections, in accordance with an embodiment of the present disclosure.
Figures 13A and 13B are plan and cross-sectional views that illustrate another stage in the example process for forming a standard cell layout of an integrated circuit with frontside and backside connections, in accordance with an embodiment of the present disclosure.
Figure 14 illustrates a cross-sectional view of a chip package containing one or more semiconductor dies, in accordance with some embodiments of the present disclosure.
Figure 15 illustrates a computing system including one or more integrated circuits, as variously described herein, in accordance with an embodiment of the present disclosure.

Although the following Detailed Description will proceed with reference being made to illustrative embodiments, many alternatives, modifications, and variations thereof will be apparent in light of this disclosure. As will be further appreciated, the figures are not necessarily drawn to scale or intended to limit the present disclosure to the specific configurations shown. For instance, while some figures generally indicate perfectly straight lines, right angles, and smooth surfaces, an actual implementation of an integrated circuit structure may have less than perfect straight lines, right angles (e.g., some features may have tapered sidewalls and/or rounded corners), and some features may have surface topology or otherwise be non-smooth, given real world limitations of the processing equipment and techniques used.

### DETAILED DESCRIPTION

Techniques are provided herein to form an integrated circuit with a standard cell layout that can utilize both frontside and backside connections along with a tighter pitch between the devices. According to some such examples, the standard cell layout may include two total transistors with one transistor being an n-channel device with the other being a p-channel device. The transistors may be configured, for instance, as an inverter or other functional circuit. According to some embodiments, a pitch between the transistors may be reduced compared to conventional layouts in part due to a reduction in a thickness of a shallow trench isolation (STI) layer. The thinner STI layer reduces the aspect ratio (AR) of direct-etched backside contacts made beneath source or drain regions of the devices. The techniques can be used in any number of transistor technologies, but are particularly useful in gate-all-around (GAA) (e.g., nanoribbon) transistor configurations or forksheet transistor configurations. In some such examples, each of the devices of the standard cell may be GAA transistors each having a number of nanoribbons (e.g., one to four) extending in the same direction. Other standard cell layouts may include, for instance, four total transistors arranged in a NAND or a NOR configuration. Still other standard cells may be configured differently. Numerous variations and embodiments will be apparent in light of this disclosure.

### General Overview

As previously noted above, there remain a number of non-trivial challenges with respect to integrated circuit fabrication. The boundaries of a standard unit cell define the layout, for instance, of at least a single combinatorial field-effect-transistor (CFET) architecture (e.g., one n-channel transistor and one p-channel transistor). The CFET architecture in the standard unit cell can be used to provide logic circuits, such as an inverter circuit, an AND-gate, an OR-gate, a NAND-gate, or a NOR-gate, and may be repeated across a larger layout of the integrated circuit. Some standard cell layouts may include two CFET architectures (e.g., four total transistors) arranged in a NAND or a NOR configuration. The size of the standard cell is typically constrained by the pitch (P) between the devices (with the size of the cell being limited to no less than 2x of P). Accordingly, scaling the standard unit cell size is reliant upon the pitch scaling of the devices, which can be challenging. One of those challenges involves connecting power and ground rails to the elements of the transistors in a way that avoids having too much cross-talk or other parasitic effects.

Thus, and in accordance with an embodiment of the present disclosure, techniques are provided herein to form a layout for a standard unit cell that includes both frontside and backside contacts to provide both frontside and backside options for delivering power and ground to the transistor elements. Additionally, the STI layer beneath the gate has a reduced thickness to reduce the aspect ratio of the backside contacts and allow for a tighter pitch P between the devices. According to some embodiments, the standard cell includes a first semiconductor device having a first semiconductor region extending lengthwise in a first direction between first source or drain regions and a second semiconductor device having a second semiconductor region extending lengthwise in the first direction (e.g., parallel to the first semiconductor region) between second source or drain regions. A gate structure extends in a second direction substantially orthogonal to the first direction across both the first and second semiconductor regions. According to some embodiments, each of the first and second source or drain regions include both a topside contact and a backside contact to facilitate signal or power routing to either the frontside (topside or top surface) or backside (bottom-side or bottom surface). The pitch P between the devices may be reduced to between about 20 nm and about 80 nm, or between about 20 nm and about 40 nm, which is at least in part facilitated by a reduction in the thickness of the STI layer to be less than 50 nm or between about 40 nm and about 50 nm.

According to an embodiment, an integrated circuit includes a semiconductor region extending from a source or drain region in a first direction, a gate structure extending over the semiconductor region in a second direction different from the first direction, a dielectric layer beneath the gate structure and having a thickness of less than 50 nm, a backside conductive contact extending through the dielectric layer to contact a bottom surface of the source or drain region, and a topside conductive contact on a top surface of the source or drain region.

According to another embodiment, an electronic device includes a chip package having one or more dies. At least one of the one or more dies includes a semiconductor device having a semiconductor region extending from a source or drain region in a first direction and a gate structure extending over the semiconductor region in a second direction substantially orthogonal to the first direction, a dielectric layer beneath the gate structure and having a thickness of less than 50 nm, a backside conductive contact adjacent to the dielectric layer along the second direction and on a bottom surface of the source or drain region, and a topside conductive contact on a top surface of the source or drain region.

According to another embodiment, an integrated circuit includes a first semiconductor region extending from a first source or drain region in a first direction, a second semiconductor region extending from a second source or drain region in the first direction, a gate structure extending over the first semiconductor region and the second semiconductor region in a second direction different from the first direction, a dielectric layer beneath the gate structure, a backside conductive contact extending through the dielectric layer to contact a bottom surface of the first source or drain region, and a topside conductive contact on a top surface of the first source or drain region. A pitch along the second direction between the first semiconductor region and the second semiconductor region is between 20 nm and 80 nm.

The techniques can be used with any type of non-planar transistors, including finFETs (sometimes called double-gate transistors, or tri-gate transistors), or nanowire and nanoribbon transistors (sometimes called gate-all-around transistors), to name a few examples. The source and drain regions can be, for example, doped portions of a given fin or substrate, or epitaxial regions that are deposited during an etch-and-replace source/drain forming process. The dopant-type in the source and drain regions will depend on the polarity of the corresponding transistor. The gate structure can be implemented with a gate-first process or a gate-last process (sometimes called a replacement metal gate, or RMG, process), or any other gate formation process. Any number of semiconductor materials can be used in forming the transistors, such as group IV materials (e.g., silicon, germanium, silicon germanium) or group III-V materials (e.g., gallium arsenide, indium gallium arsenide).

Use of the techniques and structures provided herein may be detectable using tools such as electron microscopy including scanning/transmission electron microscopy (SEM/TEM), scanning transmission electron microscopy (STEM), nano-beam electron diffraction (NBD or NBED), and reflection electron microscopy (REM); composition mapping; x-ray crystallography or diffraction (XRD); energy-dispersive x-ray spectroscopy (EDX); secondary ion mass spectrometry (SIMS); time-of-flight SIMS (ToF-SIMS); atom probe imaging or tomography; local electrode atom probe (LEAP) techniques; 3D tomography; or high resolution physical or chemical analysis, to name a few suitable example analytical tools. For instance, in some example embodiments, such tools may indicate the presence of a repeating standard unit cell having a relatively small device pitch (e.g., between 20 nm and 80 nm) between adjacent devices. In some examples, such tools may also be used to observe a relatively thin STI layer (e.g., less than 50 nm thick), which allows for backside contacts with a relatively low height-to-width aspect ratio. The backside contacts can be directly-etched from the backside, which may be evidenced by an inward-taper as the contact extends upward toward the underside of the corresponding source or drain region.

It should be readily understood that the meaning of "above" and "over" in the present disclosure should be interpreted in the broadest manner such that "above" and "over" not only mean "directly on" something but also include the meaning of over something with an intermediate feature or a layer therebetween. Further, spatially relative terms, such as "beneath," "below," "lower," "above," "upper," "top," "bottom," and the like, may be used herein for ease of description to describe one element or feature's relationship to another element (s) or feature (s) as illustrated in the figures. The spatially relative terms are intended to encompass different orientations of the device in use or operation in addition to the orientation depicted in the figures. The apparatus may be otherwise oriented (rotated 90 degrees or at other orientations) and the spatially relative descriptors used herein may likewise be interpreted accordingly.

As used herein, the term "layer" refers to a material portion including a region with a thickness. A monolayer is a layer that consists of a single layer of atoms of a given material. A layer can extend over the entirety of an underlying or overlying structure, or may have an extent less than the extent of an underlying or overlying structure. Further, a layer can be a region of a homogeneous or inhomogeneous continuous structure, with the layer having a thickness less than the thickness of the continuous structure. For example, a layer can be located between any pair of horizontal planes between, or at, a top surface and a bottom surface of the continuous structure. A layer can extend horizontally, vertically, and/or along a tapered surface. A layer can be conformal to a given surface (whether flat or curvilinear) with a relatively uniform thickness across the entire layer.

Materials that are "compositionally different" or "compositionally distinct" as used herein refers to two materials that have different chemical compositions. This compositional difference may be, for instance, by virtue of an element that is in one material but not the other (e.g., SiGe is compositionally different than silicon), or by way of one material having all the same elements as a second material but at least one of those elements is intentionally provided at a different concentration in one material relative to the other material (e.g., SiGe having 70 atomic percent germanium is compositionally different than from SiGe having 25 atomic percent germanium). In addition to such chemical composition diversity, the materials may also have distinct dopants (e.g., gallium and magnesium) or the same dopants but at differing concentrations. In still other embodiments, compositionally distinct materials may further refer to two materials that have different crystallographic orientations. For instance, (110) silicon is compositionally distinct or different from (100) silicon. Creating a stack of different orientations could be accomplished, for instance, with blanket wafer layer transfer. If two materials are elementally different, then one of the material has an element that is not in the other material.

### Architecture

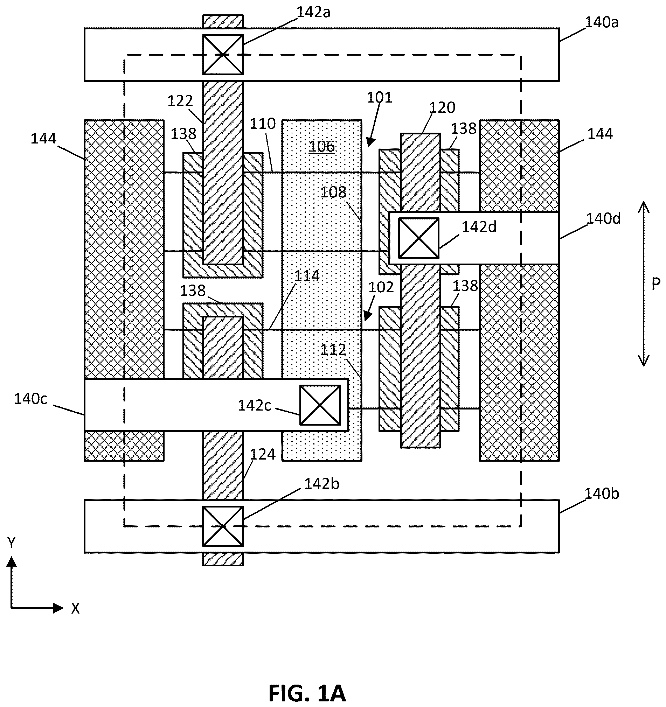

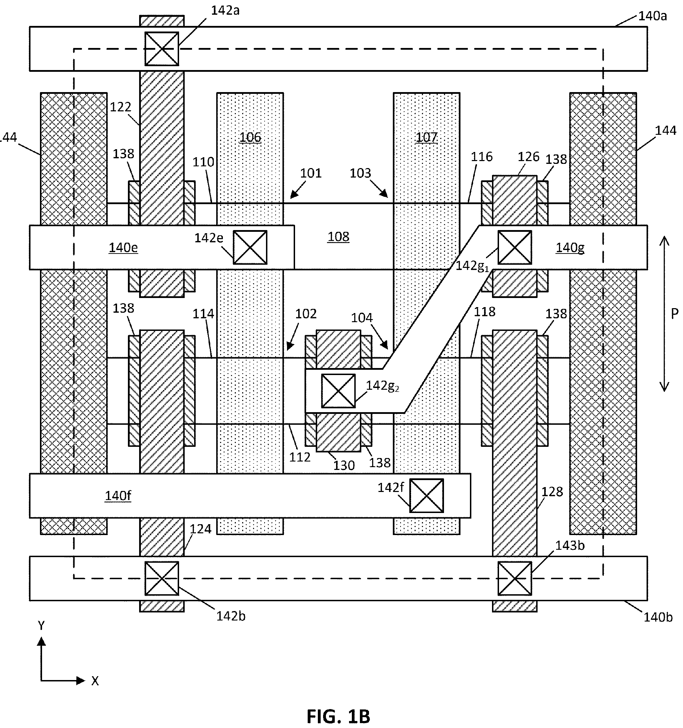

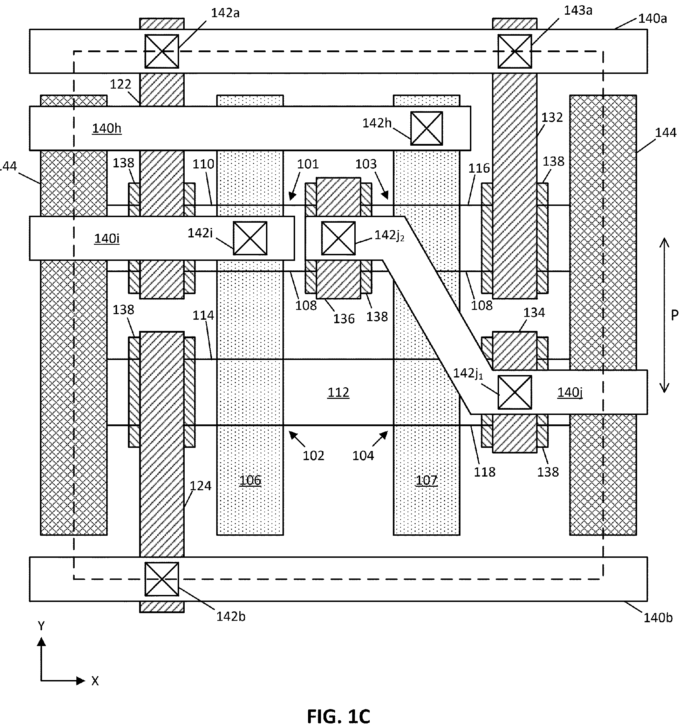

Figures 1A - 1C are plan layout views of standard unit cells with devices that include both frontside and backside contacts, according to some embodiments. The standard unit cell of Figure 1A includes a first semiconductor device 101 and a second semiconductor device 102 arranged in an inverter configuration. The standard unit cell of Figure 1B includes first semiconductor device 101, second semiconductor device 102, a third semiconductor device 103, and a fourth semiconductor device 104 arranged in a NOR configuration. The standard unit cell of Figure 1C includes first semiconductor device 101, second semiconductor device 102, third semiconductor device 103, and fourth semiconductor device 104 arranged in a NAND configuration. The boundaries of each of the standard unit cells are shown with dashed lines extending along the X-axis (e.g., a first direction) and along the Y-axis (e.g., a second direction). First semiconductor device 101 and second semiconductor device 102 share a gate structure 106 that extends along the second direction over the semiconductor regions of both first semiconductor device 101 and second semiconductor device 102, and third semiconductor device 103 and fourth semiconductor device 104 share a gate structure 107 that extends along the second direction over the semiconductor regions of both third semiconductor device 103 and fourth semiconductor device 104. The semiconductor region of first semiconductor device 101 extends between a first source or drain region 108 and a second source or drain region 110, and the semiconductor region of second semiconductor device 102 extends between a third source or drain region 112 and a fourth source or drain region 114. The semiconductor region of third semiconductor device 103 extends between first source or drain region 108 and a fifth source or drain region 116, and the semiconductor region of fourth semiconductor device 104 extends between third source or drain region 112 and a sixth source or drain region 116.

According to some embodiments, in the inverter configuration of Figure 1A, a first topside contact 120 extends along the second direction across the top surfaces of both first source or drain region 108 and third source or drain region 112, a second topside contact 122 extends along the second direction across the top surface of second source or drain region 110, and a third topside contact 124 extends along the second direction across the top surface of fourth source or drain region 114. According to some embodiments, in the NOR configuration of Figure 1B, second topside contact 122 extends along the second direction across the top surface of second source or drain region 110, third topside contact 124 extends along the second direction across the top surface of fourth source or drain region 114, a fourth topside contact 126 extends along the second direction across the top surface of fifth source or drain region 116, a fifth topside contact 128 extends along the second direction across the top surface of sixth source or drain region 118, and a sixth topside contact 130 extends along the second direction across the top surface of third source or drain region 112. According to some embodiments, in the NAND configuration of Figure 1C, second topside contact 122 extends along the second direction across the top surface of second source or drain region 110, third topside contact 124 extends along the second direction across the top surface of fourth source or drain region 114, a seventh topside contact 132 extends along the second direction across the top surface of fifth source or drain region 116, an eighth topside contact 134 extends along the second direction across the top surface of sixth source or drain region 118, and a ninth topside contact 136 extends along the second direction across the top surface of first source or drain region 108.

According to some embodiments, backside contacts 138 are provided beneath each source or drain region that also includes a corresponding topside contact. In this way, connection can be made from either the frontside or the backside to each source or drain region in any of the example standard unit cell configurations.

In the inverter configuration of Figure 1A, conductive layers 140a, 140b, 140c, and 140d extend parallel to one another along the first direction. In some embodiments, conductive layers 140a and 140b are aligned to the top and bottom boundaries of the standard unit cell. A conductive via 142a extends in the Z-direction (e.g., a third direction) to provide a conductive pathway between conductive layer 140a and second topside contact 122. Another conductive via 142b extends in the Z-direction to provide a conductive pathway between conductive layer 140b and third topside contact 124. Another conductive via 142c extends in the Z-direction to provide a conductive pathway between conductive layer 140c and gate structure 106. Another conductive via 142d extends in the Z-direction to provide a conductive pathway between conductive layer 140d and first topside contact 120. In the NOR configuration of Figure 1B, conductive layers 140a, 140b, 140e, and 140f extend parallel to one another along the first direction. Conductive layer 140g may include a bend to extend over transistor features that are separated from each other along both the first and second directions. A conductive via 142e extends in the Z-direction to provide a conductive pathway between conductive layer 140e and gate structure 106. Another conductive via 142f extends in the Z-direction to provide a conductive pathway between conductive layer 140f and gate structure 107. Another conductive via 142g₁ extends in the Z-direction to provide a conductive pathway between conductive layer 140g and fourth topside contact 126. Another conductive via 142g₂ extends in the Z-direction to provide a conductive pathway between conductive layer 140g and sixth topside contact 130. Another conductive via 143b extends in the Z-direction to provide a conductive pathway between conductive layer 140b and fifth topside contact 128. In the NAND configuration of Figure 1C, conductive layers 140a, 140b, 140h, and 140i extend parallel to one another along the first direction. Conductive layer 140j may include a bend to extend over transistor features that are separated from each other along both the first and second directions. A conductive via 142h extends in the Z-direction to provide a conductive pathway between conductive layer 140h and gate structure 107. Another conductive via 142i extends in the Z-direction to provide a conductive pathway between conductive layer 140i and gate structure 106. Another conductive via 142j₁ extends in the Z-direction to provide a conductive pathway between conductive layer 140j and eighth topside contact 134. Another conductive via 142j₂ extends in the Z-direction to provide a conductive pathway between conductive layer 140j and ninth topside contact 136. Another conductive via 143a extends in the Z-direction to provide a conductive pathway between conductive layer 140a and seventh topside contact 132.

Fin isolation structures 144 are provided on either side of semiconductor devices 101 and 102 in the inverter configuration of Figure 1A, or bookending the group of semiconductor devices 101, 102, 103, and 104 in the NOR configuration of Figure 1B and the NAND configuration of Figure 1C, according to some embodiments. Fin isolation structures 144 may include one or more dielectric materials that extend in the second direction within their respective gate trenches to cut through any number of fins present within those gate trenches. Fin isolation structures 144 may be used to isolate the semiconductor devices of the standard unit cell from any other devices formed along the first direction on either side of the standard unit cell. Fin isolation structures 144 may include any suitable dielectric material, such as silicon nitride or any other high-k dielectric material. Fin isolation structures 144 may not be needed in situations where adjacent devices along the first direction are intended to share a given source or drain region (or where dummy transistors are employed).

As noted above, the semiconductor devices of the standard unit cell of Figure 1A may be used as an inverter circuit. Thus, first semiconductor device 101 may be a PMOS device with second semiconductor device 102 being a NMOS device, or vice versa. The input signal for the inverter is received at gate structure 106, and the output signal for the inverter is taken from conductive layer 140d. As noted above, the semiconductor devices of the standard unit cell of Figure 1B may be used as a NOR gate. Thus, first semiconductor device 101 and third semiconductor device 103 may be PMOS devices with second semiconductor device 102 and fourth semiconductor device 104 being NMOS devices. The two input signals for the NOR gate are received at gate structure 106 and gate structure 107, and the output signal for the NOR gate is taken from conductive layer 140g. As noted above, the semiconductor devices of the standard unit cell of Figure 1C may be used as a NAND gate. Thus, first semiconductor device 101 and third semiconductor device 103 may be PMOS devices with second semiconductor device 102 and fourth semiconductor device 104 being NMOS devices. The two input signals for the NAND gate are received at gate structure 106 and gate structure 107, and the output signal for the NAND gate is taken from conductive layer 140j.

According to some embodiments, the pitch P along the second direction between first semiconductor device 101 and second semiconductor device 102 (and between third semiconductor device 103 and fourth semiconductor device 104) is about half the total height of the standard unit cell along the second direction. The pitch P may be reduced to less than 80 nm, such as between 20 nm and 80 nm, or between 20 nm and 40 nm. According to some embodiments, this pitch reduction for any of the standard cell configurations is made possible at least in part by reducing a thickness of the shallow trench isolation (STI) layer beneath the devices, as will be discussed in more detail herein.

It should be understood that other standard unit cell layouts may include six transistors arranged as a synchronous random access memory (SRAM) cell. In any case, the pitch P between the devices and the STI thickness between devices may be reduced as noted above to scale down the size of the standard unit cells.

### Fabrication Methodology

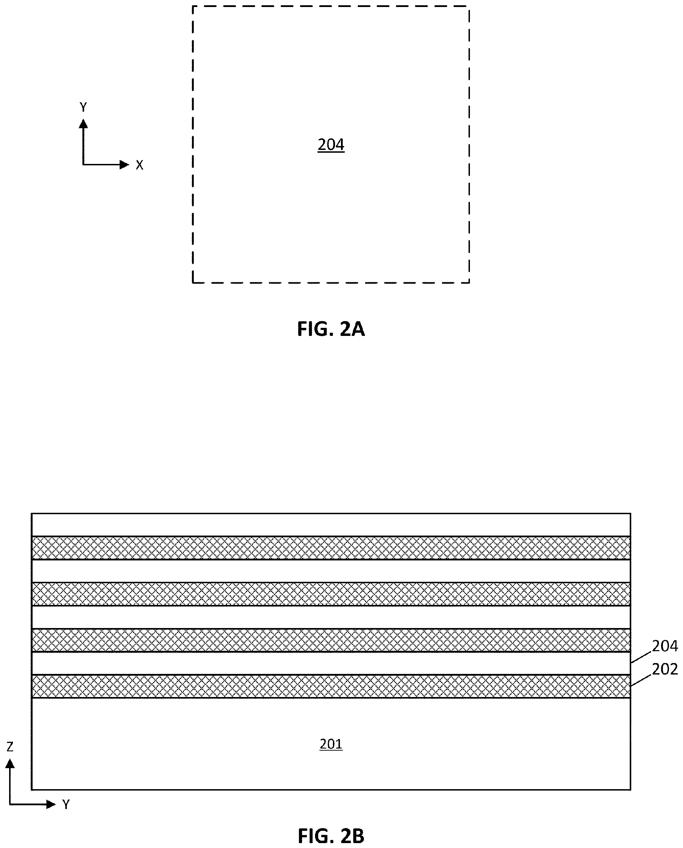

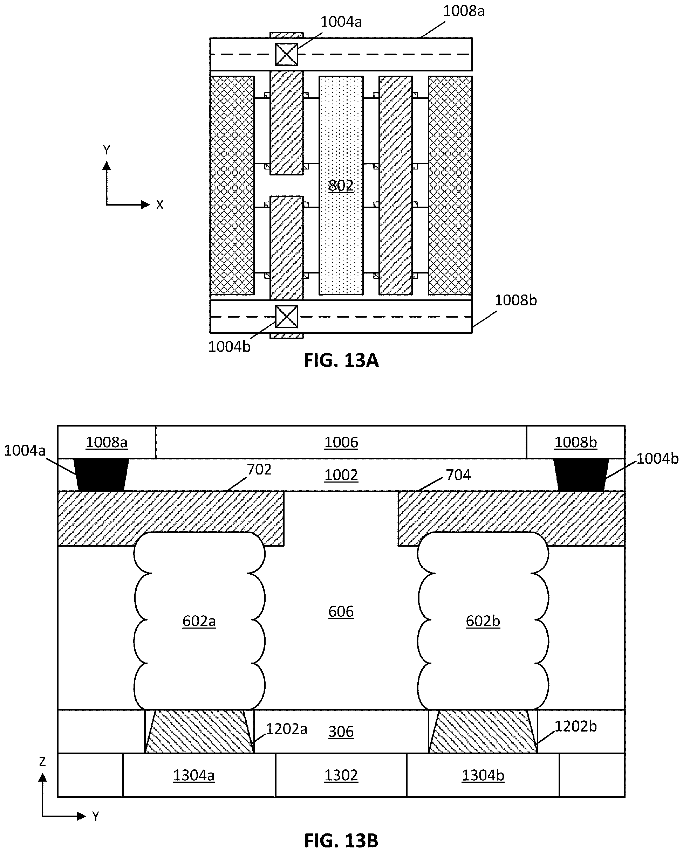

Figures 2A - 13A and 2B - 13B include plan and cross-sectional views, respectively, that collectively illustrate an example process for forming a standard cell layout of an integrated circuit with frontside and backside connections, in accordance with an embodiment of the present disclosure. Figures 2A - 13A represent a similar plan view as that of Figure 1A across the footprint of a standard unit cell with an inverter circuit, while Figures 2B - 13B represent the corresponding cross-section view along the Y-axis through the source/drain trench at each stage of the fabrication. Each set of figures sharing the same letter shows an example structure that results from the process flow up to that point in time, so the depicted structure evolves as the process flow continues, culminating in the structure shown in Figures 13A and 13B, which is similar to the structure shown in Figure 1A. Such a structure may be part of an overall integrated circuit (e.g., such as a processor or memory chip) that includes, for example, digital logic cells and/or memory cells and analog mixed signal circuitry. Thus, the illustrated integrated circuit structure may be part of a larger integrated circuit that includes other integrated circuitry not depicted. Example materials and process parameters are given, but other materials and process parameters may be used as well, as will be appreciated in light of this disclosure. Dashed lines are used in the plan view of Figures 2A - 13A to indicate the boundaries of the standard cell layout. The techniques described herein for the inverter configuration are equally applicable to any other standard cell layout (NOR, NAND, etc.) to reduce the pitch P between the devices.

Figures 2A and 2B illustrate plan and cross-section views taken through a substrate 201 having a series of material layers formed over the substrate, according to an embodiment of the present disclosure. Alternating material layers may be deposited over a substrate 201 including sacrificial layers 202 alternating with semiconductor layers 204. The alternating layers are used to form GAA transistor structures. Any number of alternating sacrificial layers 202 and semiconductor layers 204 may be deposited over substrate 201.

Substrate 201 can be, for example, a bulk substrate including group IV semiconductor material (such as silicon, germanium, or silicon germanium), group III-V semiconductor material (such as gallium arsenide, indium gallium arsenide, or indium phosphide), and/or any other suitable material upon which transistors can be formed. Alternatively, substrate 201 can be a semiconductor-on-insulator substrate having a desired semiconductor layer over a buried insulator layer (e.g., silicon over silicon dioxide). Alternatively, substrate 201 can be a multilayer substrate or superlattice suitable for forming nanowires or nanoribbons (e.g., alternating layers of silicon and SiGe, or alternating layers indium gallium arsenide and indium phosphide). Any number of substrates can be used.

According to some embodiments, semiconductor layers 204 have a different material composition than sacrificial layers 202. In some embodiments, semiconductor layers 204 are silicon germanium (SiGe) while sacrificial layers 202 include a semiconductor material suitable for use as a nanoribbon such as silicon (Si), SiGe, germanium, or III-V materials like indium phosphide (InP) or gallium arsenide (GaAs). In examples where SiGe is used in each of semiconductor layers 204 and in sacrificial layers 202, the germanium concentration is different between semiconductor layers 204 and sacrificial layers 202. For example, semiconductor layers 204 may include a higher germanium content compared to sacrificial layers 202.

While dimensions can vary from one example embodiment to the next, the thickness of each semiconductor layer 204 may be between about 4 nm and about 20 nm. In some embodiments, the thickness of each semiconductor layer 204 is substantially the same (e.g., within 1-2 nm). The thickness of each of sacrificial layers 202 may be about the same as the thickness of each semiconductor layer 204 (e.g., about 5-20 nm). Each of semiconductor layers 204 and sacrificial layers 202 may be deposited using any known material deposition technique, such as chemical vapor deposition (CVD), plasma-enhanced chemical vapor deposition (PECVD), physical vapor deposition (PVD), or atomic layer deposition (ALD), or epitaxial growth.

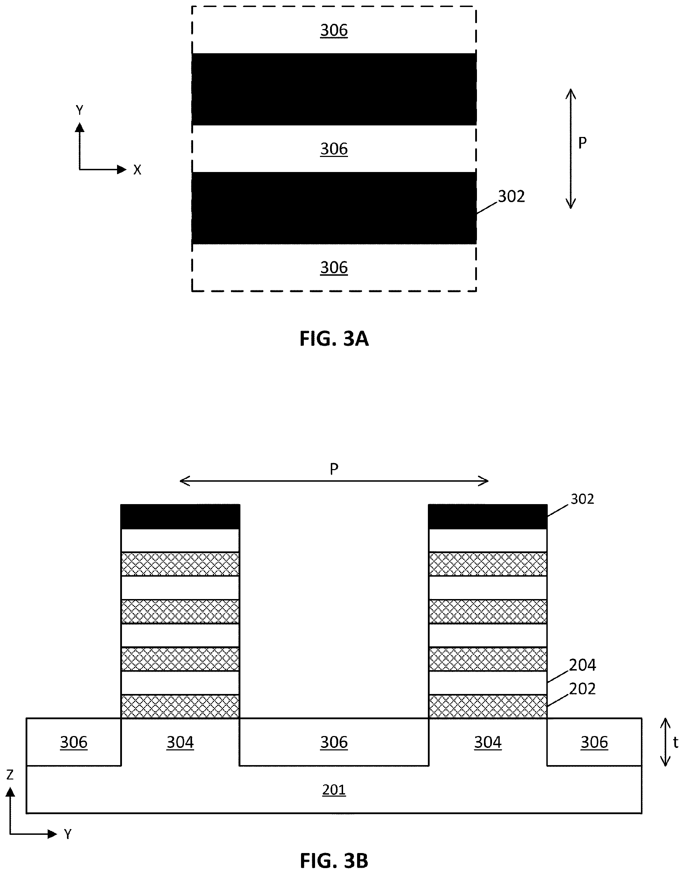

Figures 3A and 3B depict plan and cross-section views of the structure shown in Figures 2A and 2B, respectively, following the formation of a cap layer 302 and the subsequent formation of fins beneath cap layer 302, according to an embodiment. Cap layer 302 may be any suitable hard mask material such as a carbon hard mask (CHM) or silicon nitride. Cap layer 302 is patterned into rows extending along a first direction (e.g., along the X-axis as shown in Figure 3A) to form corresponding rows of fins from the alternating layer stack of sacrificial layers 202 and semiconductor layers 204.

According to some embodiments, an anisotropic etching process using, for example, reactive ion etching (RIE) through the layer stack continues into at least a portion of substrate 201. Portions of substrate 201 beneath the fins are not etched and yield subfin regions 304. The etched portion of substrate 201 may be filled with a dielectric material to from a dielectric layer 306 that acts as shallow trench isolation (STI) between adjacent fins, as seen in Figure 3B. Dielectric layer 306 may include any dielectric material such as silicon dioxide. Subfin regions 304 represent remaining portions of substrate 201 between dielectric layer 306, according to some embodiments.

According to some embodiments, a thickness (t) of dielectric layer 306 may be controlled based on the depth of the etching process into substrate 201. The thickness t may also be controlled based on how far the dielectric material is recessed after being deposited between the fins when forming dielectric layer 306. In some examples, the thickness t of dielectric layer 306 is less than 50 nm, or between about 40 nm and about 50 nm. Using a thinner dielectric layer 306 can ease design rule requirements when later forming backside contacts, which in turn allows for the fins to have a smaller pitch P between them along the second direction. In some examples, pitch P between the adjacent fins (e.g., between the adjacent semiconductor regions) is less than 80 nm, such as between 20 nm and 80 nm, or between 20 nm and 40 nm.

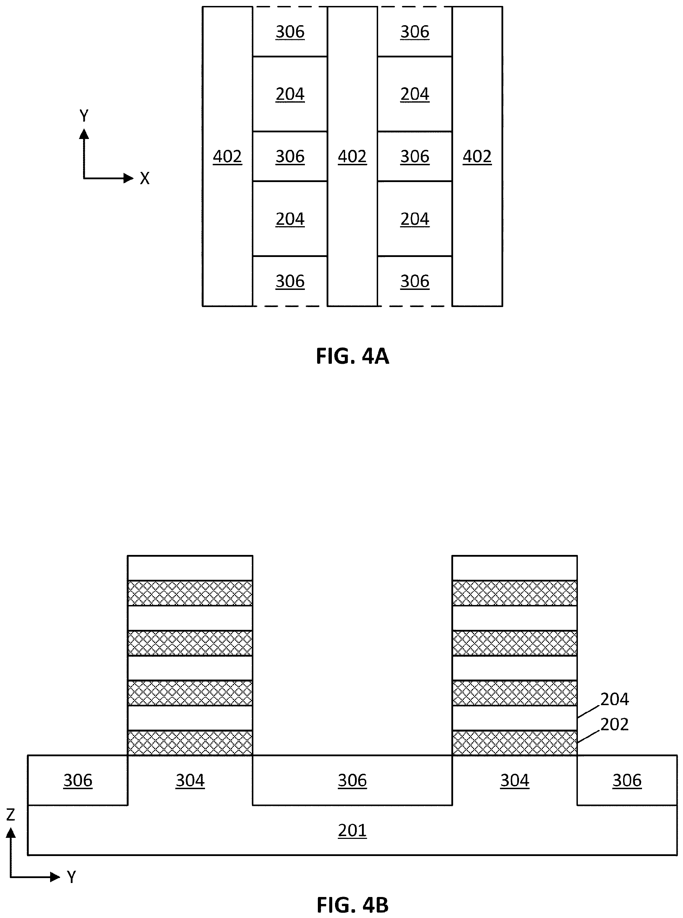

Figures 4A and 4B depict plan and cross-section views of the structure shown in Figures 3A and 3B following the formation of sacrificial gates 402, according to some embodiments. A gate masking layer may first be patterned in strips that extend orthogonally across each of the fins in a second direction (e.g., along the Y-axis as shown in Figure 4A) in order to form corresponding sacrificial gates 402 in strips beneath the gate masking layers. Afterwards, the gate masking layers may be removed or may remain as a cap layer above each sacrificial gate 402. According to some embodiments, the sacrificial gate material is removed in all areas not protected by the gate masking layers. Sacrificial gates 402 may be any material that can be selectively removed without damaging the semiconductor material of the fins. In some examples, sacrificial gates 402 includes polysilicon.

According to some embodiments, spacer structures (also referred to as gate spacers or upper gate spacers) are formed along the sidewalls of sacrificial gates 402. These spacer structures are not illustrated for clarity. The spacer structures may be deposited and then etched back such that the spacer structures remain mostly only on sidewalls of any exposed structures. According to some embodiments, the spacer structures may be any suitable dielectric material, such as silicon nitride, silicon carbon nitride, or silicon oxycarbonitride.

It should be noted that the cross-section view in Figure 4B is taken along a source/drain trench adjacent to sacrificial gates 402, and thus does not illustrate any portion of sacrificial gates 402.

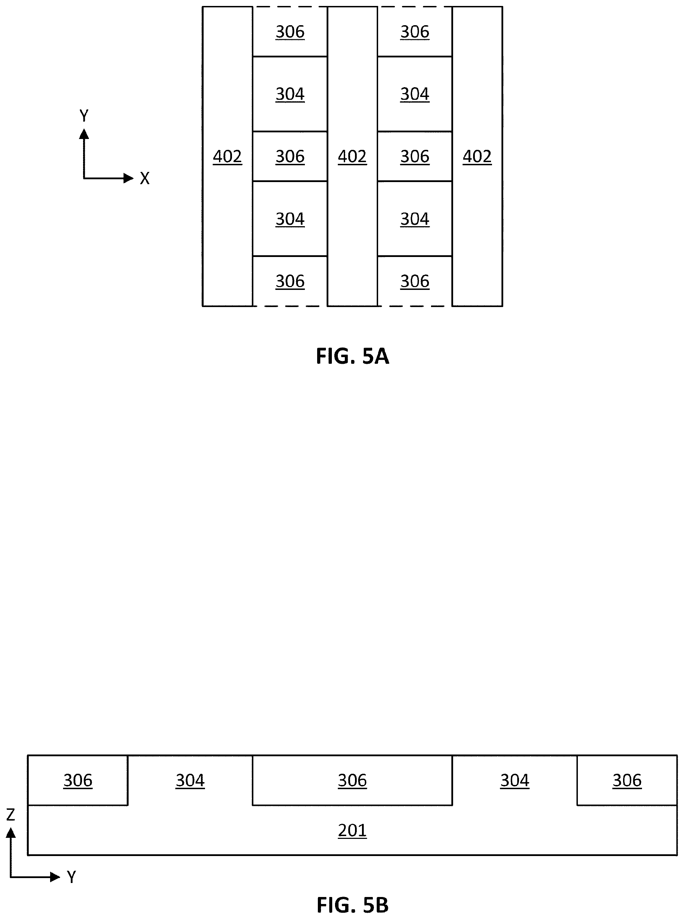

Figures 5A and 5B depict plan and cross-section views of the structure shown in Figures 4A and 4B following the removal of exposed portions of the fins not protected by sacrificial gates 402 (and the spacer structures), according to some embodiments. The exposed fin portions may be removed using any anisotropic etching process, such as RIE. The removal of the exposed fin portions creates source or drain trenches that alternate with gate trenches (currently filled with sacrificial gates 402) along the first direction, according to some embodiments. At least a portion of subfin regions 304 may be removed during the etching process.

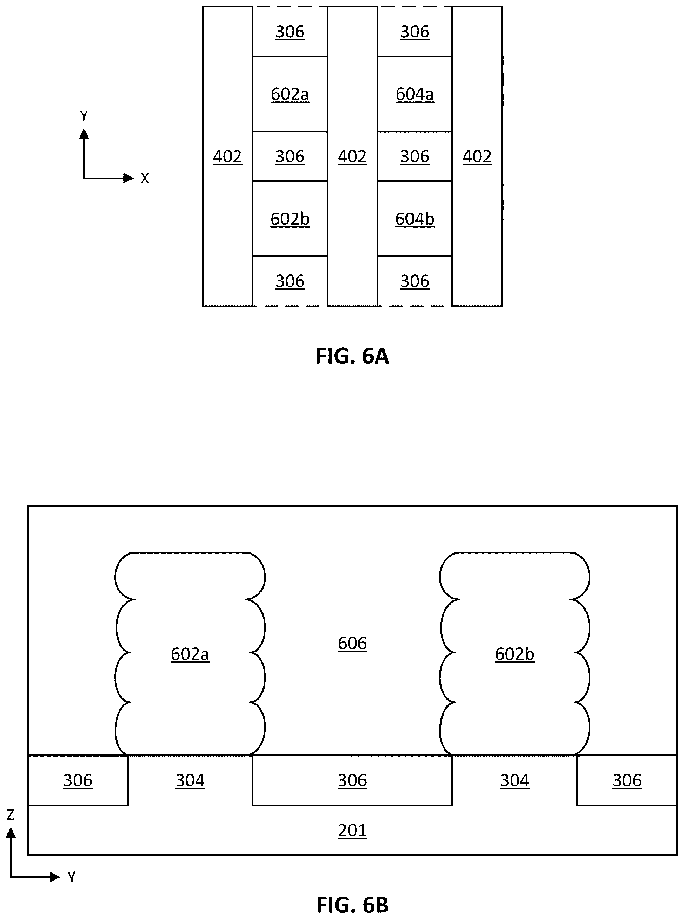

Figures 6A and 6B depict plan and cross-section views of the structure shown in Figures 5A and 5B following the formation of various source or drain regions within the source/drain trenches, according to some embodiments. Each of source or drain regions 602a/602b/604a/604b may be formed in the areas that had been previously occupied by the exposed fins within the source/drain trenches. According to some embodiments, the source or drain regions are epitaxially grown from the exposed semiconductor material at the ends of the semiconductor layers beneath the sacrificial gates 402. In some example embodiments, source or drain regions 602a and 604a are p-type source or drain regions (e.g., epitaxial silicon germanium) while source or drain regions 602b and 604b are n-type source or drain regions (e.g., epitaxial silicon), or vice versa. Accordingly, source or drain regions of one dopant type may be formed first before the formation of source or drain regions of the other dopant type.

According to some embodiments, a dielectric fill 606 is provided between adjacent source or drain regions along the source/drain trench. In some examples, dielectric fill 606 occupies a remaining volume within the source/drain trench around and over each of source or drain regions 602a and 602b, as seen in Figure 6B. Dielectric fill 606 may be any dielectric material, such as silicon dioxide. In some examples, dielectric fill 606 extends up to and planar with a top surface of sacrificial gate 402 (e.g., following a polishing procedure). A planarization process such as chemical mechanical polish (CMP) can be used to remove any excess dielectric fill 606 and planarize the structure, as shown.

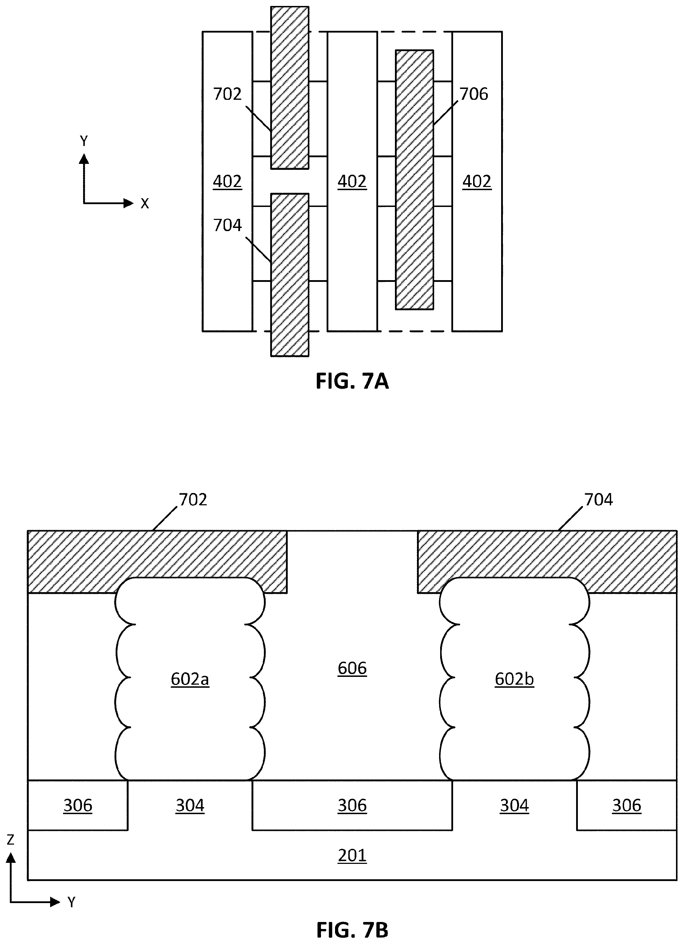

Figures 7A and 7B depict plan and cross-section views of the structure shown in Figures 6A and 6B following the formation of various topside contacts on the top surfaces of the source or drain regions, according to some embodiments. Topside contacts 702, 704, and 706 may include any conductive material, such as tungsten, molybdenum, cobalt, titanium, tantalum, ruthenium, or any alloys thereof, for making electrical contact with the underlying source or drain regions. As seen in the cross section of Figure 7B, portions of dielectric fill 606 are recessed to expose at least the top surfaces of source or drain regions 602a and 602b, and topside contacts 702 and 704 are formed within the respective recesses using any suitable metal deposition process. According to some embodiments, topside contact 706 may extend along the second direction across the top surfaces of multiple source or drain regions, such as the top surfaces of each of source or drain regions 604a and 604b.

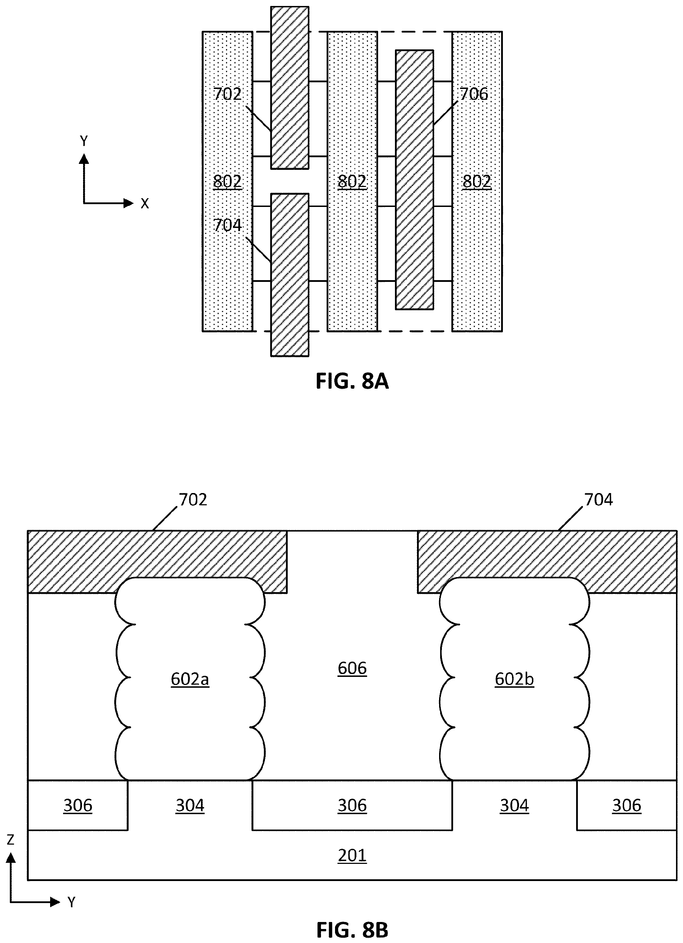

Figures 8A and 8B depict plan and cross-section views of the structure shown in Figures 7A and 7B, respectively, following the removal of sacrificial gates 402 and sacrificial layers 202 and subsequent formation of gate structures 802, according to some embodiments. In examples where gate masking layers are still present, they would be removed at this time. Once sacrificial gates 402 are removed, the fins extending between the corresponding source or drain regions are exposed.

In the example where the fins include alternating semiconductor layers, sacrificial layers 202 are selectively removed to leave behind nanoribbons that extend between corresponding source or drain regions. Each vertical set of nanoribbons represents the semiconductor region (or channel region) of a different semiconductor device. Note that the use of the term nanoribbon is not intended to exclude any particular geometries usable for a gate-all-around channel region (such as nanowires). In other embodiments, the nanoribbons of a given channel region may be a single fin structure, so as to provide a double-gate or tri-gate configuration. In still other embodiments, the nanoribbons of a given channel region may be nanosheets extending laterally from a dielectric wall, so as to provide a forksheet configuration. Sacrificial gates 402 and sacrificial layers 202 may be removed using the same isotropic etching process or different isotropic etching processes.

According to some embodiments, gate structures 802 are formed within the gate trenches over the nanoribbons or fins extending between corresponding source or drain regions. Gate structures 802 each include a gate dielectric and a gate electrode. The gate dielectric may be first formed around the nanoribbons or fin prior to the formation of the gate electrode, which may include one or more conductive layers. The gate dielectric may include any gate dielectric material (such as silicon dioxide, and/or a high-k dielectric material). Examples of high-k dielectric materials include, for instance, hafnium oxide, hafnium silicon oxide, lanthanum oxide, lanthanum aluminum oxide, zirconium oxide, zirconium silicon oxide, tantalum oxide, titanium oxide, barium strontium titanium oxide, barium titanium oxide, strontium titanium oxide, yttrium oxide, aluminum oxide, lead scandium tantalum oxide, and lead zinc niobate, to provide some examples. According to some embodiments, the gate dielectric includes a layer of hafnium oxide with a thickness between about 1 nm and about 5 nm. In some embodiments, the gate dielectric may include one or more silicates (e.g., titanium silicate, tungsten silicate, niobium silicate, and silicates of other transition metals). In some cases, the gate dielectric includes a first layer on the nanoribbons or fin, and a second layer on the first layer. The first layer can be, for instance, an oxide of the semiconductor material of the nanoribbons or fin (e.g., silicon dioxide) and the second layer can be a high-k dielectric material (e.g., hafnium oxide).

The one or more conductive layers that make up the gate electrode may be deposited using electroplating, electroless plating, CVD, PECVD, ALD, or PVD, to name a few examples. In some embodiments, the gate electrode includes doped polysilicon, a metal, or a metal alloy. Example metals or metal alloys include aluminum, tungsten, cobalt, molybdenum, ruthenium, titanium, tantalum, copper, and carbides and nitrides thereof. The gate electrode may include, for instance, a metal fill material along with one or more workfunction layers, resistance-reducing layers, and/or barrier layers. The workfunction layers can include, for example, p-type workfunction materials (e.g., titanium nitride) for PMOS gates, or n-type workfunction materials (e.g., titanium aluminum carbide) for NMOS gates. It should be understood that topside contacts 702, 704, and 706 may be formed either before or after the formation of gate structures 802.

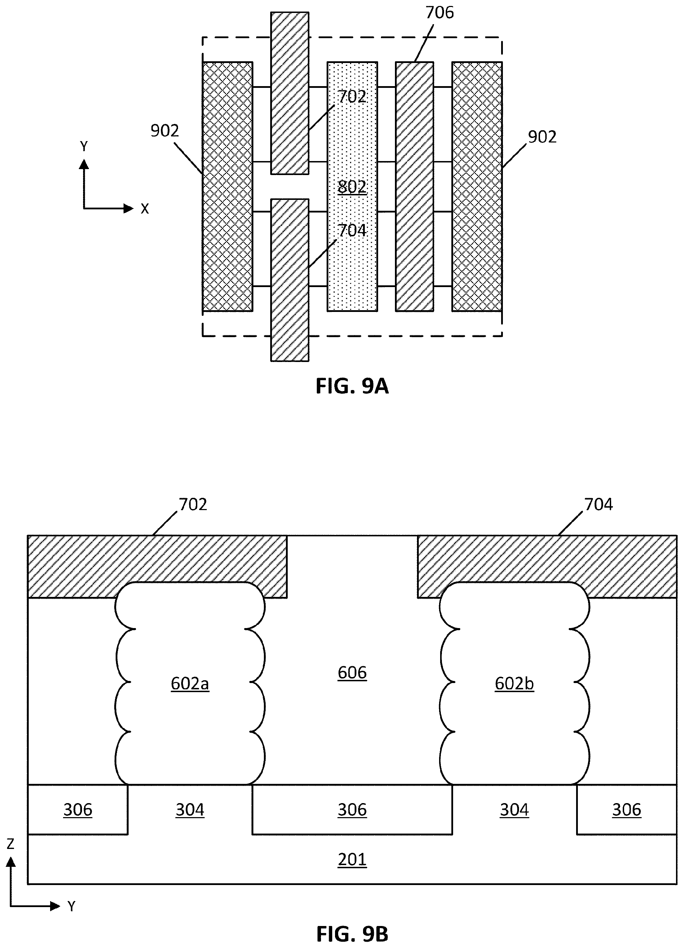

Figures 9A and 9B depict plan and cross-section views of the structure shown in Figures 8A and 8B, respectively, following the removal of the gate structures along the edges of the standard unit cell, and formation of fin isolation structures 902 in place of the removed gate structures, according to some embodiments. In some examples, an RIE process is used to remove the gate structures on either side of the illustrated gate structure 802 and fill those gate trenches with a dielectric material to form fin isolation structures 902. Fin isolation structures 902 may include one or more dielectric materials that extend in the second direction within their respective gate trenches to cut through any number of fins present within those gate trenches. In the illustrated example, fin isolation structures 902 isolate the semiconductor devices of the standard unit cell from any other devices formed along the first direction on either side of the standard unit cell. Fin isolation structures 902 may include any suitable dielectric material, such as silicon nitride or any other high-k dielectric material. Fin isolation structures 902 may not be needed in situations where adjacent devices along the first direction are intended to share a given source or drain region (or where dummy transistors are employed).

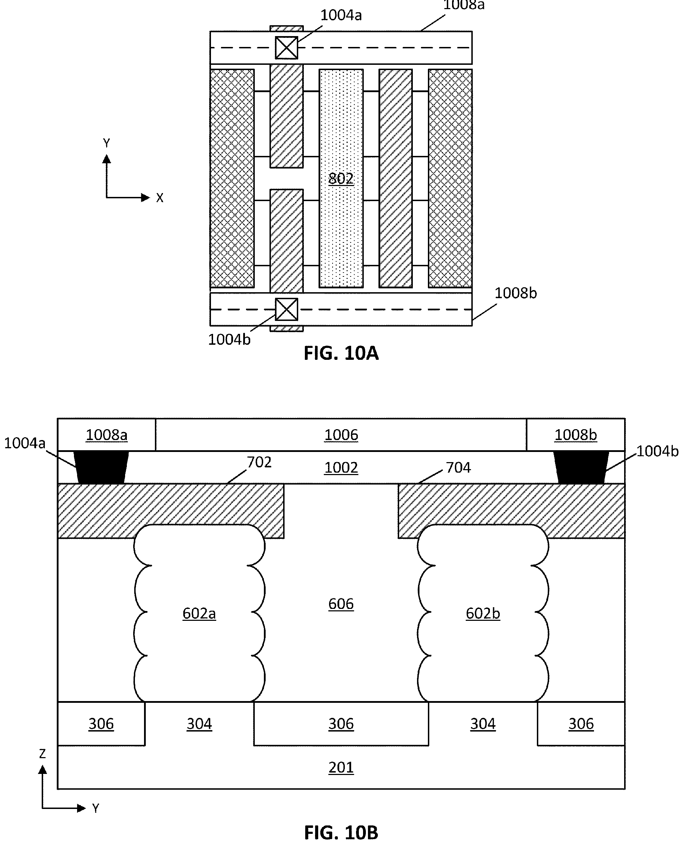

Figures 10A and 10B depict plan and cross-section views of the structure shown in Figures 9A and 9B, respectively, following the formation of a topside interconnect region having any number of interconnect layers, according to some embodiments. Each interconnect layer includes a dielectric layer along with one or more conductive vias or conductive layers. In the illustrated example, a first interconnect layer includes a first topside dielectric layer 1002, a first conductive via 1004a extending through first topside dielectric layer 1002 and contacting the underlying topside contact 702, and a second conductive via 1004b extending through first topside dielectric layer 1002 and contacting the underlying topside contact 704. Any number of other similar vias may be provided through first topside dielectric layer 1002 to contact topside contact 706. In the illustrated example, a second interconnect layer includes a second dielectric layer 1006, a first topside conductive layer 1008a, and a second topside conductive layer 1008b. According to some embodiments, first via 1004a extends in the third direction between first topside conductive layer 1008a and topside contact 702, and second via 1004b extends in the third direction between second topside conductive layer 1008b and topside contact 704. According to some embodiments, first topside conductive layer 1008a and second topside conductive layer 1008b each extends in the first direction along the boundaries of the standard unit cell as seen more clearly in Figure 10A. Any number of other topside interconnect layers may be formed to route power and/or signal to various transistor elements. Note that other topside conductive layers used to route signals to gate structure 802 and/or to topside contact 706 are not shown in Figure 10A for clarity.

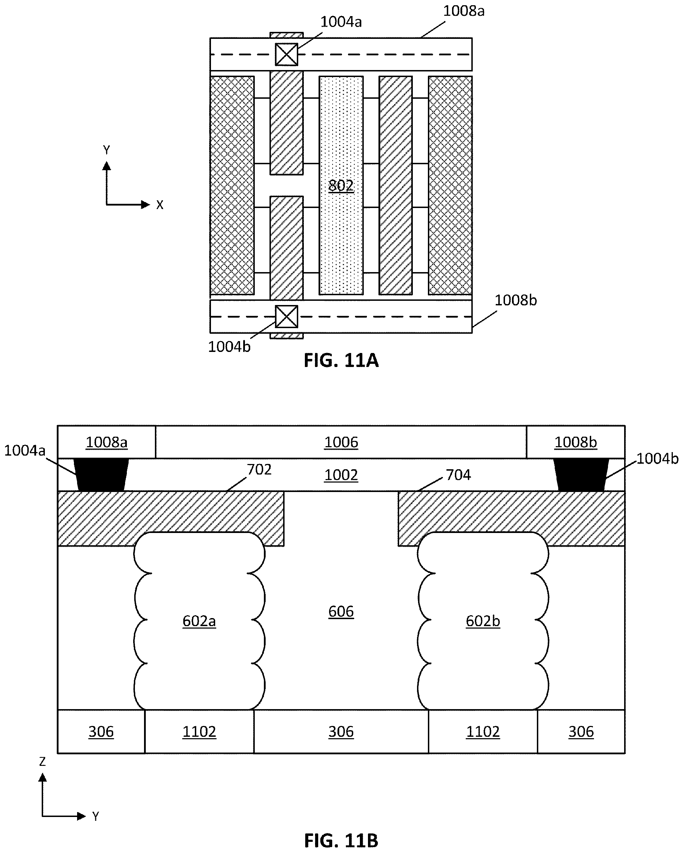

Figures 11A and 11B depict plan and cross-section views of the structure shown in Figures 9A and 9B, respectively, following the removal of substrate 201 from the backside, which exposes the bottom surface of dielectric layer 306 and subfins 304, according to some embodiments. Substrate 201 may be removed using any combination of polishing, grinding, or isotropic etching processes. The backside exposed subfin regions 304 may then be etched away using any suitable isotropic etching process to yield backside cavities. According to some embodiments, one or more additional dielectric layers may be deposited within the backside cavities to form a dielectric fill 1102. Dielectric fill 1102 along with dielectric layer 306 may collectively form a base dielectric structure beneath the devices. According to some embodiments, a bottom surface of the base dielectric structure (bottom surfaces of both dielectric layer 306 and dielectric fill 1102) may be polished to be a substantially planar surface.

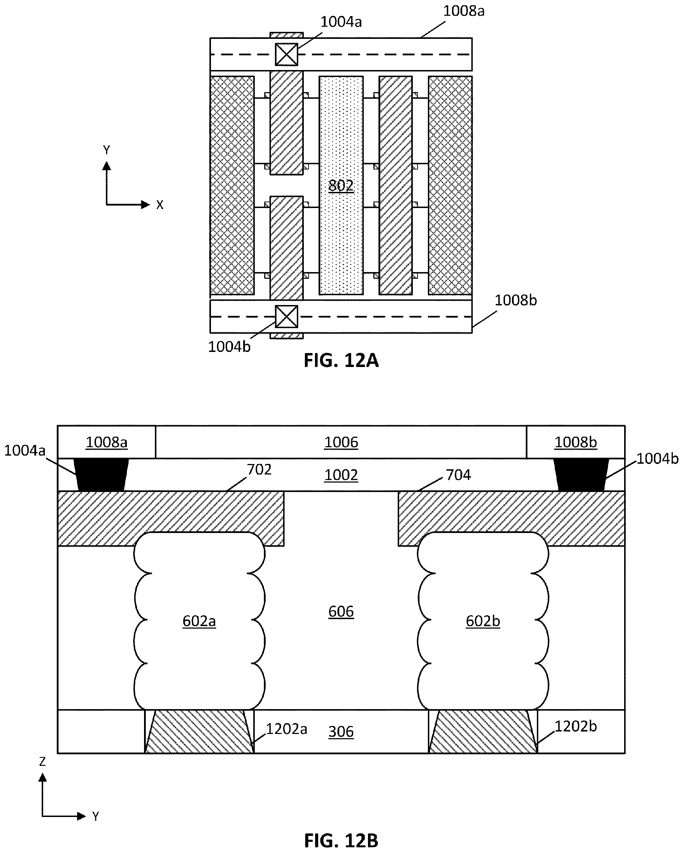

Figures 12A and 12B depict plan and cross-section views of the structure shown in Figures 11A and 11B, respectively, following the formation of backside contacts 1202a and 1202b through the base dielectric structure (e.g., through dielectric fill 1102), according to some embodiments. A directional etching process may be performed to create any number of backside cavities through the base dielectric structure, according to some embodiments. For example, a RIE process may be used to anisotropically etch through unmasked (e.g., exposed) portions of the base dielectric structure not protected by a mask structure. As a result of the etching process, the backside cavities have a tapering profile with a width that decreases from the opening of the cavity (e.g., at the bottom surface of the base dielectric structure towards the bottom surface of the source or drain regions 602a and 602b, according to some embodiments. One or more conductive materials may be deposited within the backside cavities to form backside contacts 1202a and 1202b. For example, backside contacts 1202a and 1202b may include any of tungsten, ruthenium, molybdenum, or cobalt. Due to the tapering profile of the backside cavities, the width of backside contacts 1202a and 1202b may be about 3 nm greater, or between 2 nm and 5 nm greater, at the bottom surface of the base dielectric structure compared to the bottom surface of source or drain regions 602a and 602b. Since dielectric layer 306 was initially formed to be relatively thin (e.g., less than 50 nm), the aspect ratio of backside contacts 1202a and 1202b may be relatively small, such as less than 4:1, less than 3:1, or less than 2:1.

Figures 12A and 12B depict plan and cross-section views of the structure shown in Figures 11A and 11B, respectively, following the formation of a backside interconnect region having any number of interconnect layers, according to some embodiments. Similarly to the frontside interconnect region, each interconnect layer can include a dielectric layer along with one or more conductive vias or conductive layers. In the illustrated example, a backside interconnect layer includes a backside dielectric layer 1302, a first backside conductive layer 1304a extending through dielectric layer 1302 and contacting backside contact 1202a, and a second backside conductive layer 1304b extending through dielectric layer 1302 and contacting backside contact 1202b. Each of first backside conductive layer 1304a and second backside conductive layer 1304b can include any suitable conductive material, such as any of tungsten, ruthenium, molybdenum, or cobalt. First backside conductive layer 1304a and second backside conductive layer 1304b may extend parallel to one another along the first direction to route power and/or signal to the corresponding source or drain regions 602a/602b. According to some embodiments, first backside conductive layer 1304a and second backside conductive layer 1304b are comparatively wider along the second direction compared to first topside conductive layer 1008a and second topside conductive layer 1008b. In some examples, the backside conductive layers 1304a/1304b are at least 1.5x, 2x, 2.5x wider than topside conductive layers 1008a/1008b. The backside layers may be made wider due to the relaxed spacing requirements for interconnect layers on the backside of the structure, and the wider geometry makes them more suitable for use as power or ground rails for the circuit.

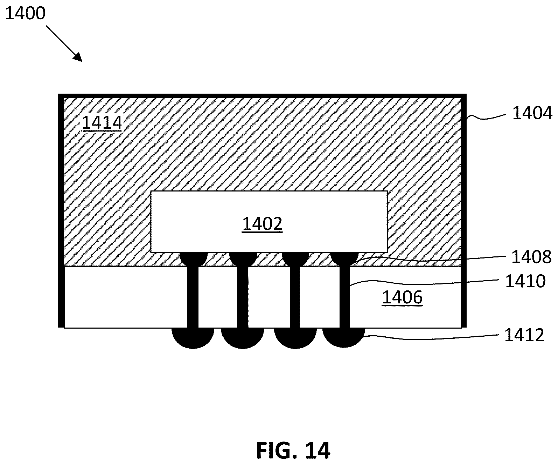

Figure 14 illustrates an example embodiment of a chip package 1400, in accordance with an embodiment of the present disclosure. As can be seen, chip package 1400 includes one or more dies 1402. One or more dies 1402 may include at least one integrated circuit having semiconductor devices, such as any of the semiconductor devices disclosed herein. One or more dies 1402 may include any other circuitry used to interface with other devices formed on the dies, or other devices connected to chip package 1400, in some example configurations.

As can be further seen, chip package 1400 includes a housing 1404 that is bonded to a package substrate 1406. The housing 1404 may be any standard or proprietary housing, and may provide, for example, electromagnetic shielding and environmental protection for the components of chip package 1400. The one or more dies 1402 may be conductively coupled to a package substrate 1406 using connections 1408, which may be implemented with any number of standard or proprietary connection mechanisms, such as solder bumps, ball grid array (BGA), pins, or wire bonds, to name a few examples. Package substrate 1406 may be any standard or proprietary package substrate, but in some cases includes a dielectric material having conductive pathways (e.g., including conductive vias and lines) extending through the dielectric material between the faces of package substrate 1406, or between different locations on each face. In some embodiments, package substrate 1406 may have a thickness less than 1 millimeter (e.g., between 0.1 millimeters and 0.5 millimeters), although any number of package geometries can be used. Additional conductive contacts 1412 may be disposed at an opposite face of package substrate 1406 for conductively contacting, for instance, a printed circuit board (PCB). One or more vias 1410 extend through a thickness of package substrate 1406 to provide conductive pathways between one or more of connections 1408 to one or more of contacts 1412. Vias 1410 are illustrated as single straight columns through package substrate 1406 for ease of illustration, although other configurations can be used (e.g., damascene, dual damascene, through-silicon via, or an interconnect structure that meanders through the thickness of substrate 1406 to contact one or more intermediate locations therein). In still other embodiments, vias 1410 are fabricated by multiple smaller stacked vias, or are staggered at different locations across package substrate 1406. In the illustrated embodiment, contacts 1412 are solder balls (e.g., for bump-based connections or a ball grid array arrangement), but any suitable package bonding mechanism may be used (e.g., pins in a pin grid array arrangement or lands in a land grid array arrangement). In some embodiments, a solder resist is disposed between contacts 1412, to inhibit shorting.

In some embodiments, a mold material 1414 may be disposed around the one or more dies 1402 included within housing 1404 (e.g., between dies 1402 and package substrate 1406 as an underfill material, as well as between dies 1402 and housing 1404 as an overfill material). Although the dimensions and qualities of the mold material 1414 can vary from one embodiment to the next, in some embodiments, a thickness of mold material 1414 is less than 1 millimeter. Example materials that may be used for mold material 1414 include epoxy mold materials, as suitable. In some cases, the mold material 1414 is thermally conductive, in addition to being electrically insulating.

### Example System

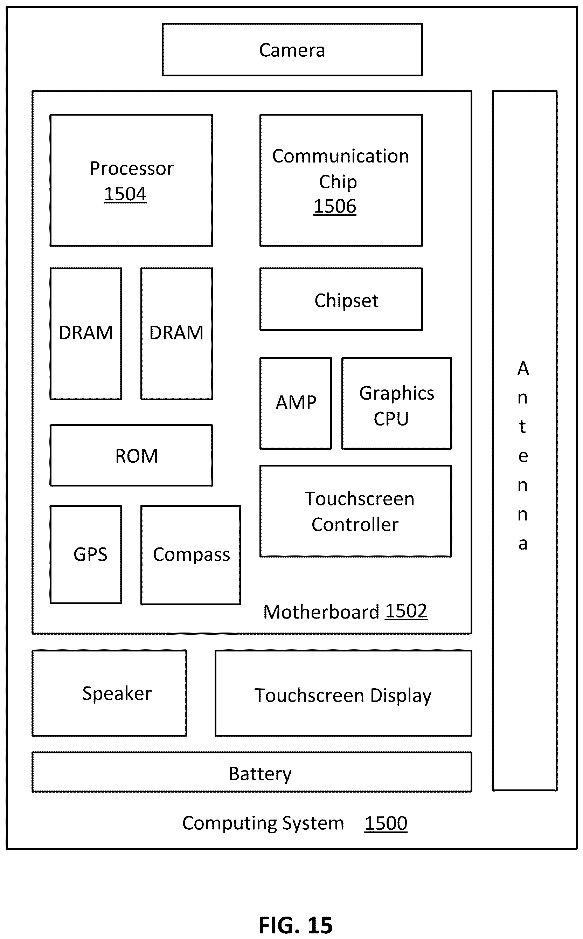

FIG. 15 is an example computing system implemented with one or more of the integrated circuit structures as disclosed herein, in accordance with some embodiments of the present disclosure. As can be seen, the computing system 1500 houses a motherboard 1502. The motherboard 1502 may include a number of components, including, but not limited to, a processor 1504 and at least one communication chip 1506, each of which can be physically and electrically coupled to the motherboard 1502, or otherwise integrated therein. As will be appreciated, the motherboard 1502 may be, for example, any printed circuit board (PCB), whether a main board, a daughterboard mounted on a main board, or the only board of system 1500, etc.

Depending on its applications, computing system 1500 may include one or more other components that may or may not be physically and electrically coupled to the motherboard 1502. These other components may include, but are not limited to, volatile memory (e.g., DRAM), non-volatile memory (e.g., ROM), a graphics processor, a digital signal processor, a crypto processor, a chipset, an antenna, a display, a touchscreen display, a touchscreen controller, a battery, an audio codec, a video codec, a power amplifier, a global positioning system (GPS) device, a compass, an accelerometer, a gyroscope, a speaker, a camera, and a mass storage device (such as hard disk drive, compact disk (CD), digital versatile disk (DVD), and so forth). Any of the components included in computing system 1500 may include one or more integrated circuit structures or devices configured in accordance with an example embodiment (e.g., a module including one or more semiconductor devices that include a standard cell layout having both backside and frontside contacts to the source or drain regions, as variously provided herein). In some embodiments, multiple functions can be integrated into one or more chips (e.g., for instance, note that the communication chip 1506 can be part of or otherwise integrated into the processor 1504).

The communication chip 1506 enables wireless communications for the transfer of data to and from the computing system 1500. The term "wireless" and its derivatives may be used to describe circuits, devices, systems, methods, techniques, communications channels, etc., that may communicate data through the use of modulated electromagnetic radiation through a non-solid medium. The term does not imply that the associated devices do not contain any wires, although in some embodiments they might not. The communication chip 1506 may implement any of a number of wireless standards or protocols, including, but not limited to, Wi-Fi (IEEE 802.11 family), WiMAX (IEEE 802.16 family), IEEE 802.20, long term evolution (LTE), Ev-DO, HSPA+, HSDPA+, HSUPA+, EDGE, GSM, GPRS, CDMA, TDMA, DECT, Bluetooth, derivatives thereof, as well as any other wireless protocols that are designated as 3G, 4G, 5G, and beyond. The computing system 1500 may include a plurality of communication chips 1506. For instance, a first communication chip 1506 may be dedicated to shorter range wireless communications such as Wi-Fi and Bluetooth and a second communication chip 1506 may be dedicated to longer range wireless communications such as GPS, EDGE, GPRS, CDMA, WiMAX, LTE, Ev-DO, and others.

The processor 1504 of the computing system 1500 includes an integrated circuit die packaged within the processor 1504. In some embodiments, the integrated circuit die of the processor includes onboard circuitry that is implemented with one or more semiconductor devices as variously described herein. The term "processor" may refer to any device or portion of a device that processes, for instance, electronic data from registers and/or memory to transform that electronic data into other electronic data that may be stored in registers and/or memory.

The communication chip 1506 also may include an integrated circuit die packaged within the communication chip 1506. In accordance with some such example embodiments, the integrated circuit die of the communication chip includes one or more semiconductor devices as variously described herein. As will be appreciated in light of this disclosure, note that multi-standard wireless capability may be integrated directly into the processor 1504 (e.g., where functionality of any chips 1506 is integrated into processor 1504, rather than having separate communication chips). Further note that processor 1504 may be a chip set having such wireless capability. In short, any number of processor 1504 and/or communication chips 1506 can be used. Likewise, any one chip or chip set can have multiple functions integrated therein.

In various implementations, the computing system 1500 may be a laptop, a netbook, a notebook, a smartphone, a tablet, a personal digital assistant (PDA), an ultra-mobile PC, a mobile phone, a desktop computer, a server, a printer, a scanner, a monitor, a set-top box, an entertainment control unit, a digital camera, a portable music player, a digital video recorder, or any other electronic device that processes data or employs one or more integrated circuit structures or devices formed using the disclosed techniques, as variously described herein.

It will be appreciated that in some embodiments, the various components of the computing system 1500 may be combined or integrated in a system-on-a-chip (SoC) architecture. In some embodiments, the components may be hardware components, firmware components, software components or any suitable combination of hardware, firmware or software.

### Further Example Embodiments

The following examples pertain to further embodiments, from which numerous permutations and configurations will be apparent.

Example 1 is an integrated circuit that includes a semiconductor region extending from a source or drain region in a first direction, a gate structure extending over the semiconductor region in a second direction different from the first direction, a dielectric layer beneath the gate structure and having a thickness of less than 50 nm, a backside conductive contact extending through the dielectric layer to contact a bottom surface of the source or drain region, and a topside conductive contact on a top surface of the source or drain region.

Example 2 includes the integrated circuit of Example 1, wherein the dielectric layer has a thickness between 40 nm and 50 nm.

Example 3 includes the integrated circuit of Example 1 or 2, wherein the semiconductor region comprises one or more semiconductor nanoribbons.

Example 4 includes the integrated circuit of Example 3, wherein the one or more semiconductor nanoribbons comprises germanium, silicon, or any combination thereof.

Example 5 includes the integrated circuit of any one of Examples 1-4, wherein the source or drain region is a first source or drain region and the semiconductor region extends from the first source or drain region to a second source or drain region along the first direction.

Example 6 includes the integrated circuit of Example 5, wherein the topside conductive contact is a first topside contact extending in the second direction over the top surface of the first source or drain region and the integrated circuit further comprises a second topside conductive contact that extends along the second direction on the top surface of the second source or drain region.

Example 7 includes the integrated circuit of any one of Examples 1-6, further comprising: a via on the topside conductive contact; a first conductive layer on the via such that the via extends in a third direction between the topside conductive contact and the first conductive layer, the third direction being substantially orthogonal to the first and second directions; and a second conductive layer beneath the backside conductive contact and contacting the backside conductive contact.

Example 8 includes the integrated circuit of Example 7, wherein the first conducive layer and the second conductive layer each extend along the first direction.

Example 9 includes the integrated circuit of any one of Examples 1-8, wherein the backside conductive contact has a tapered width along the first direction such that a first width of the backside conductive contact at a bottom surface of the dielectric layer is greater than a second width of the backside conductive contact at the bottom surface of the source or drain region.

Example 10 is a die that includes the integrated circuit of any one of Examples 1-9.

Example 11 is an electronic device that includes a chip package having one or more dies. At least one of the one or more dies includes a semiconductor device having a semiconductor region extending from a source or drain region in a first direction and a gate structure extending over the semiconductor region in a second direction substantially orthogonal to the first direction, a dielectric layer beneath the gate structure and having a thickness of less than 50 nm, a backside conductive contact adjacent to the dielectric layer along the second direction and on a bottom surface of the source or drain region, and a topside conductive contact on a top surface of the source or drain region.

Example 12 includes the electronic device of Example 11, wherein the dielectric layer has a thickness between 40 nm and 50 nm.

Example 13 includes the electronic device of Example 11 or 12, wherein the semiconductor region comprises one or more semiconductor nanoribbons.

Example 14 includes the electronic device of Example 13, wherein the one or more semiconductor nanoribbons comprises germanium, silicon, or any combination thereof.

Example 15 includes the electronic device of any one of Examples 11-14, wherein the source or drain region is a first source or drain region and the semiconductor region extends from the first source or drain region to a second source or drain region along the first direction.

Example 16 includes the electronic device of Example 15, wherein the topside conductive contact is a first topside contact extending in the second direction over the top surface of the first source or drain region and the at least one of the one or more dies further comprises a second topside conductive contact that extends along the second direction on the top surface of the second source or drain region.

Example 17 includes the electronic device of any one of Examples 11-16, wherein the at least one of the one or more dies further comprises: a via on the topside conductive contact; a first conductive layer on the via such that the via extends in a third direction between the topside conductive contact and the first conductive layer, the third direction being substantially orthogonal to the first and second directions; and a second conductive layer beneath the backside conductive contact and contacting the backside conductive contact.

Example 18 includes the electronic device of Example 17, wherein the first conducive layer and the second conductive layer each extend along the first direction.

Example 19 includes the electronic device of any one of Examples 11-18, wherein the backside conductive contact has a tapered width along the first direction such that a first width of the backside conductive contact at a bottom surface of the dielectric layer is greater than a second width of the backside conductive contact at the bottom surface of the source or drain region.

Example 20 includes the electronic device of any one of Examples 11-19, further comprising a printed circuit board, wherein the chip package is attached to the printed circuit board.

Example 21 is an integrated circuit that includes a first semiconductor region extending from a first source or drain region in a first direction, a second semiconductor region extending from a second source or drain region in the first direction, a gate structure extending over the first semiconductor region and the second semiconductor region in a second direction different from the first direction, a dielectric layer beneath the gate structure, a backside conductive contact extending through the dielectric layer to contact a bottom surface of the first source or drain region, and a topside conductive contact on a top surface of the first source or drain region. A pitch along the second direction between the first semiconductor region and the second semiconductor region is between 20 nm and 80 nm.

Example 22 includes the integrated circuit of Example 21, wherein the dielectric layer has a thickness between 40 nm and 50 nm.

Example 23 includes the integrated circuit of Example 21 or 22, wherein the semiconductor region comprises one or more semiconductor nanoribbons.

Example 24 includes the integrated circuit of Example 23, wherein the one or more semiconductor nanoribbons comprises germanium, silicon, or any combination thereof.

Example 25 includes the integrated circuit of any one of Examples 21-24, wherein the first semiconductor region extends from the first source or drain region to a third source or drain region along the first direction.

Example 26 includes the integrated circuit of Example 25, wherein the topside conductive contact is a first topside contact extending in the second direction over the top surface of the first source or drain region and the integrated circuit further comprises a second topside conductive contact that extends along the second direction on the top surface of the second source or drain region.

Example 27 includes the integrated circuit of any one of Examples 21-26, further comprising: a via on the topside conductive contact; a first conductive layer on the via such that the via extends in a third direction between the topside conductive contact and the first conductive layer, the third direction being substantially orthogonal to the first and second directions; and a second conductive layer beneath the backside conductive contact and contacting the backside conductive contact.

Example 28 includes the integrated circuit of Example 27, wherein the first conducive layer and the second conductive layer each extend along the first direction.

Example 29 includes the integrated circuit of any one of Examples 21-28, wherein the backside conductive contact has a tapered width along the first direction such that a first width of the backside conductive contact at a bottom surface of the dielectric layer is greater than a second width of the backside conductive contact at the bottom surface of the source or drain region.

Example 30 includes the integrated circuit of any one of Examples 21-29, wherein the first semiconductor region and the second semiconductor region are part of a standard unit cell having a height along the second direction that is about twice the pitch between the first semiconductor region and the second semiconductor region.

Example 31 includes the integrated circuit of any one of Examples 21-30, wherein the pitch along the second direction between the first semiconductor region and the second semiconductor region is between 20 nm and 40 nm.

Example 32 is a die that includes the integrated circuit of any one of Examples 21-31.

The foregoing description of the embodiments of the disclosure has been presented for the purposes of illustration and description. It is not intended to be exhaustive or to limit the disclosure to the precise forms disclosed. Many modifications and variations are possible in light of this disclosure. It is intended that the scope of the disclosure be limited not by this detailed description, but rather by the claims appended hereto.

## Claims

1. An integrated circuit comprising:
a semiconductor region extending from a source or drain region in a first direction;
a gate structure extending over the semiconductor region in a second direction different from the first direction;
a dielectric layer beneath the gate structure, the dielectric layer having a thickness of less than 50 nm;
a backside conductive contact extending through the dielectric layer to contact a bottom surface of the source or drain region; and
a topside conductive contact on a top surface of the source or drain region.

2. The integrated circuit of claim 1, wherein the dielectric layer has a thickness between 40 nm and 50 nm.

3. The integrated circuit of claim 1 or 2, wherein the semiconductor region comprises one or more semiconductor nanoribbons.

4. The integrated circuit of claim 3, wherein the one or more semiconductor nanoribbons comprises germanium, silicon, or any combination thereof.

5. The integrated circuit of any one of claims 1-4, wherein the source or drain region is a first source or drain region and the semiconductor region extends from the first source or drain region to a second source or drain region along the first direction.

6. The integrated circuit of claim 5, wherein the topside conductive contact is a first topside contact extending in the second direction over the top surface of the first source or drain region and the integrated circuit further comprises a second topside conductive contact that extends along the second direction on the top surface of the second source or drain region.

7. The integrated circuit of any one of claims 1-6, further comprising:
a via on the topside conductive contact;
a first conductive layer on the via such that the via extends in a third direction between the topside conductive contact and the first conductive layer, the third direction being substantially orthogonal to the first and second directions; and
a second conductive layer beneath the backside conductive contact and contacting the backside conductive contact.

8. The integrated circuit of claim 7, wherein the first conductive layer and the second conductive layer each extend along the first direction.

9. The integrated circuit of any one of claims 1-8, wherein the backside conductive contact has a tapered width along the first direction such that a first width of the backside conductive contact at a bottom surface of the dielectric layer is greater than a second width of the backside conductive contact at the bottom surface of the source or drain region.

10. A die that includes the integrated circuit of any one of claims 1-9.

11. An integrated circuit comprising:
a first semiconductor region extending from a first source or drain region in a first direction;
a second semiconductor region extending from a second source or drain region in the first direction;
a gate structure extending over the first semiconductor region and the second semiconductor region in a second direction different from the first direction;
a dielectric layer beneath the gate structure;
a backside conductive contact extending through the dielectric layer to contact a bottom surface of the first source or drain region; and
a topside conductive contact on a top surface of the first source or drain region,
wherein a pitch along the second direction between the first semiconductor region and the second semiconductor region is between 20 nm and 80 nm.

12. The integrated circuit of claim 11, wherein the dielectric layer has a thickness between 40 nm and 50 nm.

13. The integrated circuit of claim 11 or 12, wherein the first semiconductor region extends from the first source or drain region to a third source or drain region along the first direction, and wherein the topside conductive contact is a first topside contact extending in the second direction over the top surface of the first source or drain region, and the integrated circuit further comprises a second topside conductive contact that extends along the second direction on the top surface of the second source or drain region.

14. The integrated circuit of any one of claims 11-13, further comprising:
a via on the topside conductive contact;
a first conductive layer on the via such that the via extends in a third direction between the topside conductive contact and the first conductive layer, the third direction being substantially orthogonal to the first and second directions; and
a second conductive layer beneath the backside conductive contact and contacting the backside conductive contact.

15. The integrated circuit of any one of claims 11-14, wherein the first semiconductor region and the second semiconductor region are part of a standard unit cell having a height along the second direction that is about twice the pitch between the first semiconductor region and the second semiconductor region.
